(19) **Europäisches Patentamt / European Patent Office / Office européen des brevets**

(11) **EP 3 149 506 B1**

(12) **FASCICULE DE BREVET EUROPEEN**

(45) Date de publication et mention
de la délivrance du brevet:
**26.12.2018 Bulletin 2018/52**

(21) Numéro de dépôt: **15727355.8**

(22) Date de dépôt: **29.05.2015**

(51) Int Cl.:
*G01R 33/04* (2006.01)        *G01R 15/20* (2006.01)
*H04B 1/18* (2006.01)        *H04B 1/52* (2015.01)
*H04B 1/54* (2006.01)

(86) Numéro de dépôt international:
**PCT/EP2015/062040**

(87) Numéro de publication internationale:
**WO 2015/181382 (03.12.2015 Gazette 2015/48)**

(54) **ADAPTATEUR D'ANTENNE**

ANTENNENADAPTER

ANTENNA ADAPTER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **30.05.2014  FR 1401253**

(43) Date de publication de la demande:
**05.04.2017   Bulletin 2017/14**

(73) Titulaire: **THALES
92400 Courbevoie (FR)**

(72) Inventeurs:
• **DESURVIRE, Emmanuel
F-91767 Palaiseau (FR)**

• **CASTERA, Jean-Paul
F-91767 Palaiseau (FR)**
• **DEMOTES-MAINARD, Bertrand
F-92526 Neuilly sur Seine Cedex (FR)**

(74) Mandataire: **Lavoix
2, place d'Estienne d'Orves
75441 Paris Cedex 09 (FR)**

(56) Documents cités:
**EP-A1- 1 039 307        US-A- 5 285 155
US-A1- 2009 224 609        US-A1- 2011 065 585
US-B1- 6 690 162**

## Description

L'invention a pour domaine celui des systèmes antennaires radiofréquences et, plus particulièrement des adaptateurs de ces systèmes, situés entre l'antenne et le circuit de réception.

Généralement, un adaptateur est conçu pour opérer à l'intérieur d'une bande passante limitée, centrée sur une fréquence f prédéfinie.

A cet effet, l'adaptateur inclut une capacité et/ou une inductance fixe ou variable, permettant un fonctionnement en mode résonateur de l'adaptateur.

Cependant, dans certaines applications, il est souhaitable que le système antennaire puisse fonctionner sur une large bande passante. C'est par exemple le cas lorsque la fréquence de l'onde électromagnétique incidente sur l'antenne est inconnue, lorsque la fréquence de l'onde incidente présente une fréquence variable au cours du temps, ou encore lorsque la fréquence de l'onde incidente est aléatoire.

Pour un fonctionnement sur une bande passante large, la sensibilité du système antennaire est très réduite hors du domaine de fonctionnement en mode résonateur de l'adaptateur.

De plus, la réponse fréquentielle du système antennaire n'est pas uniforme sur l'ensemble de la bande passante.

Une solution connue consiste à inclure un filtre accordable (ou commutable par bandes) entre l'antenne et l'amplificateur, celui-ci étant constitué d'une pluralité de circuits, chaque circuit étant caractérisé par une bande passante particulière. Le filtre permet alors d'appliquer le signal au circuit le mieux adapté en impédance et donc en sensibilité.

Outre le besoin d'inclure un filtre accordable, qui constitue un composant complexe, un défaut de cette approche réside dans la perte d'insertion causée par l'ajout du filtre. Cette perte d'insertion augmente le facteur de bruit de la chaîne réceptrice du système antennaire.

De plus, par principe, un filtre accordable ne permet de recevoir qu'une partie du spectre électromagnétique. Ainsi, cette approche n'est pas adaptée au cas d'une onde incidente dont la fréquence est inconnue ou aléatoire.

Le document EP 1 039 307 A1 divulgue un appareil de détection de courant intégrant un détecteur magnétique du type volumétrique, mesurant le champ d'excitation magnétique uniforme et constant présent à l'intérieur d'une boucle de matériau ferromagnétique.

Le document US 5 285 155 A divulgue le captage d'un champ magnétique externe par une première boucle, puis la génération d'un champ secondaire par une seconde boucle 2b autour d'un capteur magnétique du type inductif. Dans ce document une contre-réaction visant à la compensation du signal issu du capteur magnétique, par la création, au voisinage de celui-ci, d'un champ magnétique de compensation par une boucle auxiliaire.

L'invention a donc pour but de pallier ces problèmes.

L'invention est notamment relative à un adaptateur d'antenne conforme aux revendications.

Le présent adaptateur fonctionne sur une bande passante très large. Il possède une très haute sensibilité, une grande dynamique, et une réponse fréquentielle uniforme.

L'invention et ses avantages seront mieux compris à la lecture de la description qui va suivre de modes de réalisation et d'utilisation, donnés uniquement à titre d'exemple, et faite en se référant aux dessins annexés sur lesquels :

- La figure 1 est une représentation de principe d'un adaptateur d'antenne mettant en oeuvre le capteur de la figure 1 ;
- La figure 2 est une représentation schématique d'un mode de réalisation dit intermédiaire de l'adaptateur d'antenne de la figure 9 ;
- La figure 3 est une représentation schématique d'un mode de réalisation dit en méandres de l'adaptateur d'antenne de la figure 9, mettant en oeuvre des magnétomètres asymétriques ;
- La figure 4 est une représentation schématique d'un mode de réalisation dit en méandres de l'adaptateur d'antenne de la figure 9, mettant en oeuvre des magnétomètres symétriques ;
- La figure 5 est une représentation simplifiée d'une intégration dense à deux dimensions des modes de réalisation dits en boucle ; et,
- La figure 6 est une représentation simplifiée d'une intégration dense à deux dimensions des modes de réalisation dits en méandres.

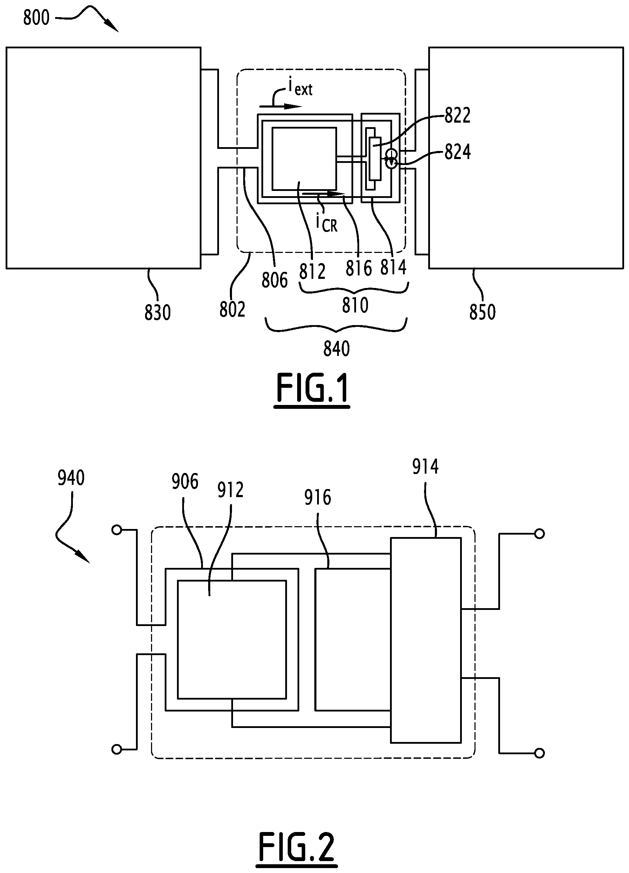

Sur la figure 1 est représenté un système antennaire 800 comportant, connectées successivement : une antenne 830, dipolaire ou magnétique ; un adaptateur d'antenne 840, servant d'interface propre à adapter l'impédance entre l'antenne et la chaîne de réception ; et une chaîne de réception 850, comportant amplificateur bas-bruit, filtre, détecteur, numérisation, et autres composants de traitement du signal.

L'adaptateur d'antenne 840 comporte un carter 802 propre à délimiter une zone isolée magnétiquement du monde extérieur et des perturbations magnétiques, notamment des ondes électromagnétiques. Le carter 802 est en un matériau adapté propre à faire écran à ces champs extérieurs.

L'adaptateur d'antenne 840 comporte, à l'intérieur du carter 802, un premier fil conducteur 806 et un capteur magnétométrique 810.

Le premier fil conducteur 806 est connecté à l'antenne 830. Il est traversé par le courant délivré par l'antenne 830, dénommé courant externe, $i_{ext}$. Lorsque le courant externe $i_{ext}$ circule dans le fil 806, il génère un champ magnétique externe $B_{ext}$ autour du fil 806, en particulier à l'intérieur du carter 802. Le champ externe $B_{ext}$ est linéaire par rapport au courant externe $i_{ext}$. Le courant externe $i_{ext}(t)$ varie au cours du temps t. Il en va donc de même du champ magnétique externe $B_{ext}(t)$.

Le capteur magnétométrique 810 est propre à mesurer le champ magnétique externe $B_{ext}(t)$ à l'intérieur du carter 802 pour obtenir indirectement une mesure du courant $i_{ext}(t)$.

Le capteur 810 comporte un senseur magnétique 812, un circuit de contrôle 814 et un second fil conducteur 816.

Un senseur magnétique 812 comporte un composant sensible au champ magnétique, qui est propre à délivrer, sous la forme d'une tension ou d'un courant, un signal de mesure V correspondant au champ magnétique dans lequel il est plongé.

Parmi les senseurs magnétiques, on connait les senseurs magnétiques optiques, tels que les senseurs à centres N-V diamant, dans lesquels la transition entre deux niveaux énergétiques des électrons d'un atome constituant une impureté dans un cristal est modifiée lorsque ce cristal est plongé dans un champ magnétique externe $B_{ext}$. La modification de la transition modifie la réponse du cristal éclairé par une lumière laser adapté. Un tel senseur magnétique fonctionne à température ambiante.

La réponse du cristal est linéaire mais sur une plage de fréquences réduite autour d'une fréquence caractéristique de la largeur de transition utilisée.

Parmi les senseurs magnétiques, on connait également les senseurs magnétiques supraconducteurs, qui sont particulièrement intéressants, puisqu'ils offrent les plus hautes sensibilités physiquement atteignables. Un tel senseur magnétique, mettant en oeuvre des matériaux supraconducteurs, fonctionne à des températures basses (autour de 80 K environ pour les matériaux supraconducteurs dits à haute température critique), ou ultra-basses, (autour du milli-Kelvin environ pour les matériaux supraconducteurs dits à basse température critique).

Un senseur magnétique supraconducteur est un composant SQUID (« Superconducting QUantumInterference Device » en anglais) ou un composant SQIF (« Superconducting Quantum Interference Filter » en anglais). Un composant SQIF est constitué d'une matrice de composants SQUID, connectés en série, en parallèle ou les deux.

Du fait de leurs principes de fonctionnement, les composants SQUID et SQIF ont une réponse non linéaire, c'est-à-dire que la tension $V(\phi)$ induite par le flux $\phi$ du champ magnétique externe $B_{ext}$ traversant une surface S du composant, n'est pas une fonction linéaire du flux $\phi_{ext}$, et par conséquent du champ magnétique externe $B_{ext}$.

Dans le cas d'un composant SQUID, cette réponse est sinusoïdale. Dans la région du point d'inflexion de la sinusoïde, le comportement est, au premier ordre, linéaire. Cependant, cette région correspond à une plage de flux relativement étroite.

Dans le cas d'un composant SQIF, la réponse est uniforme, $V(\phi)$ = este, sauf autour de certains points caractéristiques, disposés périodiquement, pour lesquels le flux $\phi_{ext}$ du champ magnétique externe $B_{ext}$ est égal à un nombre entier de fois un flux caractéristique $\phi_0$, dit « fluxon ». Ainsi, la réponse d'un composant SQIF prend la forme d'un « peigne inversé ».

Dans un composant SQIF modifié, présentant une configuration particulière, la réponse est uniforme sauf dans une région autour de l'origine, $\phi_{ext}$ = 0, où cette réponse s'annule. Dans cette région, la réponse, symétrique autour de l'origine, est quasi-linéaire. Cependant, cette région correspond à une plage de flux relativement étroite.

Le senseur magnétique 812 est un senseur magnétique supraconducteur.

Le senseur magnétique 812 est de forme parallélépipédique rectangle. Il présente une faible épaisseur et une surface active S, sensiblement plane et présentant une normale dans le sens de l'épaisseur du senseur magnétique.

Le senseur magnétique 812 est propre à générer, entre ses deux bornes de sortie, un signal de réponse, qui est ici une tension V. La tension V est une fonction du flux magnétique total instantané $\phi(t)$ à travers la surface S.

Le circuit de contrôle 814 reçoit entre ses deux bornes d'entrée, E1 et E2, le signal de réponse $V(\phi(t))$ produit par le senseur magnétique 812, et génère un courant de contre réaction $i_{CR}(t)$ entre ses deux bornes de sortie, S1 et S2.

Le circuit de contrôle 814 applique un signal proportionnel au courant de contre réaction à la chaîne de réception 850.

Plus précisément, le circuit de contrôle 814 comporte un moyen de comparaison 822 connecté aux bornes d'entrée E1 et E2, et propre à comparer le signal de réponse $V(\phi(t))$ à un signal de référence $V_0$ et à générer un signal de comparaison.

Le circuit de contrôle 814 comporte une source de courant 824 commandée par le signal de comparaison et propre à générer, entre deux bornes de sortie, le courant de contre réaction $i_{CR}(t)$.

Le fil conducteur 816 est connecté entre les bornes de sortie S1 et S2 du circuit de contrôle 814. Il est conformé pour circuler au voisinage du senseur magnétique 812. Le fil conducteur 816 est traversé par le courant de contre réaction $i_{CR}(t)$. De ce fait, il crée autour de lui un champ magnétique de contre réaction $B_{CR}(t)$. Le champ $B_{CR}(t)$ est linéaire par rapport au courant $i_{CR}(t)$. Le champ $B_{CR}(t)$ crée un flux de contre réaction $\phi_{CR}(t)$ à travers la surface S du senseur magnétique 812 : $\phi_{CR}(t)$ = $B_{CR}(t).S$

A chaque instant, le signal de réponse V(t) que délivre le senseur magnétique 812 dépend du flux magnétique total $\phi(t)$ traversant la surface S.

Ce flux total $\phi(t)$ est la somme du flux externe

$\phi_{ext}(t)$, qui résulte du champ magnétique externe $B_{ext}(t)$ à mesurer selon la relation $\phi_{ext}(t) = B_{ext}(t).S$, et du flux de contre réaction $\phi_{CR}(t)$.

Le capteur 810 est à l'équilibre lorsque le flux total $\phi(t)$ reçu par le senseur magnétique 812 est constant. Dans ce régime, forcé en permanence par la contre réaction instantanée, le courant de contre réaction $i_{CR}(t)$ représente une mesure linéaire du champ magnétique externe $B_{ext}(t)$

Pour que cet équilibre existe, les paramètres géométriques et physiques du capteur 810 sont choisis de telle sorte que le flux de contre réaction soit opposé au flux externe et que la réponse V(t) du senseur magnétique 812 puisse être instantanément ramenée au niveau de la tension de référence $V_0$. Dit autrement, le circuit de contrôle 814 et le fil conducteur 816 sont tels qu'un champ magnétique de contre réaction est créé dont le flux à travers la surface active du senseur magnétique compense substantiellement, à chaque instant, le flux du champ magnétique externe.

Il est à noter que si le champ magnétique externe $B_{ext}$ possède une composante continue, le point de stabilisation sera la tension de référence $V_0$ décalée d'une constante.

Par le choix adapté de la tension de référence $V_0$, la sensibilité maximale du capteur 810 est obtenue pour la zone de réponse du senseur magnétique 812 où la dérivée $\frac{\partial V}{\partial \phi}$ est maximale. Pour un senseur magnétique supraconducteur du type SQUID, cela correspond au point d'inflexion de la réponse sinusoïdale. Pour un senseur magnétique supraconducteur du type SQIF modifié, cela correspond au point d'origine, éventuellement légèrement décalé pour éviter les ambiguïtés sur le signe du champ et donc sur celui du courant dues à la réponse symétrique d'un tel senseur magnétique.

Il est à souligner que dans le capteur magnétométrique 810, le signal de réponse du senseur magnétique 812 n'est pas considéré comme un signal de mesure, mais comme un signal de régulation d'une boucle de contre réaction. C'est le signal de contre réaction qui constitue le signal de mesure.

Ainsi, l'adaptateur d'antenne présente une grande sensibilité, un comportement linéaire et uniforme sur une bande passante étendue, en contraignant le fonctionnement du senseur magnétique dans la région étroite où il présente une grande sensibilité et un comportement linéaire.

Avantageusement, pour que le capteur présente une bonne sensibilité, du fait de la forme circulaire des lignes de champ magnétique autour d'un fil parcouru par un courant, les premier et second fils 806 et 816 sont disposés dans le plan P de la surface S du senseur magnétique 812.

De plus, dans le cas où le courant externe n'a pas de composante continue et où les premier et second fils 806 et 816 sont situés de façon parfaitement symétrique autour du senseur magnétique 812, le courant de contre réaction est, à chaque instant, la contrepartie exacte du courant externe à mesurer : $i_{CR}(t) = i_{ext}(t)$

Il est possible d'introduire un facteur d'amplification de courant, défini par :

$$G = |i_{CR}(t)|/|i_{ext}(t)|,$$

par le choix d'une géométrie dans laquelle le second fil 816 est placé à une distance x2 du centre du senseur magnétique 812 qui est plus grande que la distance x1 à laquelle le premier fil 306 est placé du centre du senseur magnétique 812.

Le rôle de l'adaptateur d'antenne 840 est élargi à un rôle de convertisseur de signal large-bande. Il restitue le signal sous la forme d'un courant, et non d'une tension.

La chaîne de réception 850 dispose d'un signal radiofréquence non sujet a pré-filtrage, d'où sa propriété de « large-bande ».

L'adaptateur d'antenne 840 présente une configuration en boucle.

Le premier fil 806 est conformé pour constituer une première boucle autour du senseur magnétique 812. Celui-ci mesure alors un flux $\phi_{ext}(t)$ induit par une boucle de courant, plutôt que par un fil conducteur rectiligne. En supposant une boucle circulaire, un facteur multiplicatif égal à $\pi$ est ainsi introduit par rapport à une configuration dans laquelle les deux fils sont rectilignes.

De plus, en conformant le premier fil 806 pour que la première boucle comporte N1>1 spires, le flux externe $\phi_{ext}(t)$ à travers la surface S est multiplié par un facteur N1.

L'introduction de ces facteurs multiplicatifs permet d'augmenter la sensibilité de l'adaptateur.

Le second fil 816 est également conformé pour former une seconde boucle comportant N2 spires.

Avec des première et seconde boucles de même diamètre, un facteur d'amplification G entier est obtenu de manière simple en choisissant une configuration où N1 est égal à G et N2 à 1. Plus généralement un facteur d'amplification G entier est obtenu de manière simple en choisissant : $\frac{N2}{N1} = G$.

Cette configuration en boucle présente une réponse large-bande.

La bande passante est limitée aux fréquences hautes principalement par un effet de résistance radiative, $R_{rad}$, qui est proportionnelle à $f^4$, où f est la fréquence du courant de contre réaction $i_{CR}$. La résistance radiative domine ici sur une autre limitation qui est due à l'inductance de la boucle formée par le fil 816, cette inductance étant proportionnelle à f.

En diminuant les dimensions du circuit formé par le fil conducteur 816, la résistance radiative $R_{rad}$ peut être réduite de façon à repousser au maximum la fréquence de coupure haute du capteur 810.

Un autre inconvénient est que la première boucle induit un courant « parasite » $i_{ind}(t)$ dans la seconde boucle, selon la loi :

$$Z.\,i_{ind}(t) = -e\frac{\partial\phi_{ext}(t)}{\partial t}$$

Où Z est l'impédance de la seconde boucle de contre réaction.

Ces deux boucles se comportent ainsi comme un transformateur de courant, et $i_{ind}(t)$ représente une mesure du courant externe $i_{ext}(t)$.

Pour exploiter la propriété du senseur magnétique, le circuit de contrôle 814 est alors adapté pour générer un courant de contre réaction tel que :

$$i_{CR}(t) = 2.\,i_{ind}(t)$$

Le courant de contre-réaction est injecté dans le second fil de manière à circuler dans le sens opposé à celui du courant induit.

Ceci a pour effet d'annuler exactement (à une constante près) le flux total dans le senseur magnétique 812 et donc d'asservir proprement le courant de contre réaction.

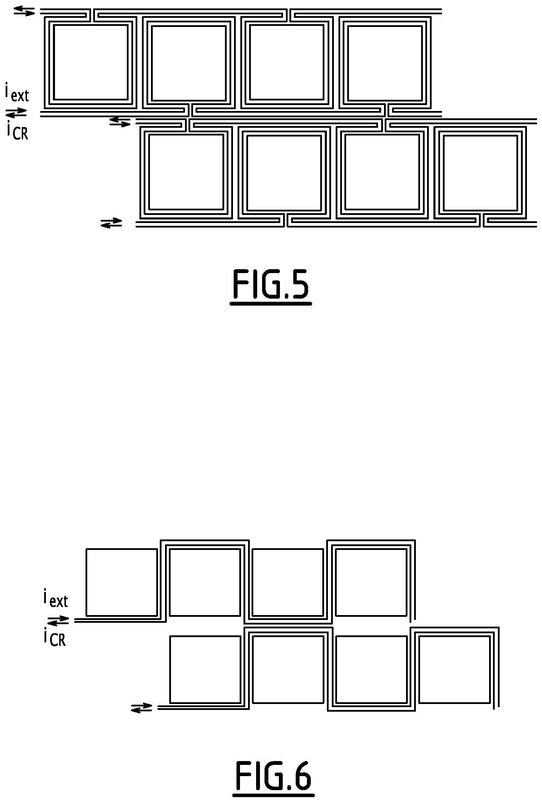

La configuration en boucle autorise une intégration dense à une ou deux dimensions dans le plan P, comme cela est représenté schématiquement sur la figure 5.

Cette configuration en boucle permet la réalisation d'un capteur magnétique aux dimensions réduites.

A la figure 2, est représenté un adaptateur d'antenne 940 qui constitue un mode de réalisation intermédiaire entre la configuration à deux boucles et la configuration à deux fils rectilignes. Un élément de l'adaptateur de la figure 2 identique ou similaire à un élément correspondant de l'adaptateur de la figure 1 est repéré par le même chiffre de référence que cet élément correspondant augmenté d'une centaine.

Dans ce mode de réalisation, si le premier fil 906 est conformé en une première boucle, le second fil 916 est rectiligne.

L'avantage est ici de permettre l'élimination du courant parasite induit $i_{ind}(t)$ dans le second fil par le premier fil dans l'adaptateur 840. L'impédance du capteur magnétométrique 910 est ainsi fortement réduite, tout en conservant la sensibilité importante à cause de la présence du facteur $\pi.N1$ de la première boucle par rapport à la configuration où les deux fils sont rectilignes (figure 1).

Un autre avantage de cette configuration intermédiaire réside dans le fait que pour compenser exactement le flux externe, il est nécessaire d'appliquer un courant de contre réaction qui a une intensité $\pi$ fois plus importante que l'intensité du courant de contre réaction de l'adaptateur d'antenne 840. Ainsi, le gain total sur le courant de contre réaction, c'est-à-dire le courant de mesure, est ici de : $G = \pi^2.N1$, soit par exemple $G = 100$ pour $N1=10$.

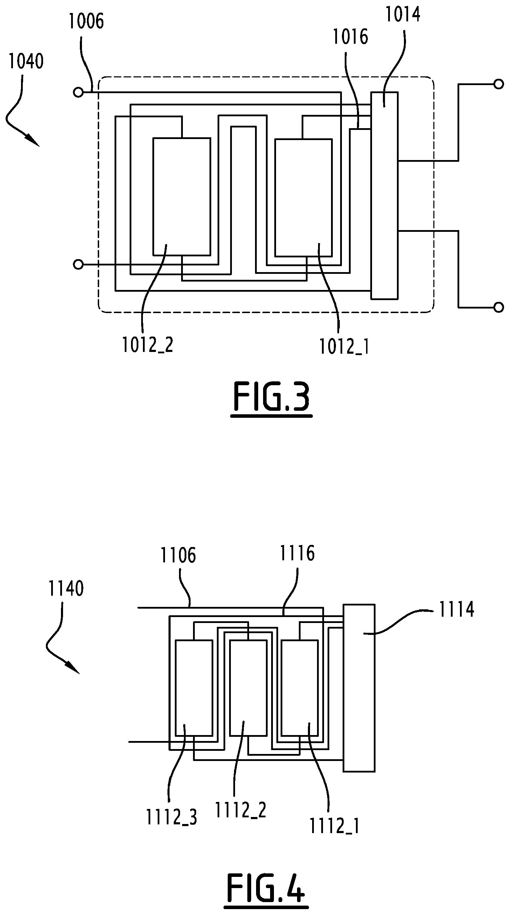

Les figures 3 et 4 représentent deux adaptateurs d'antenne selon un mode de réalisation en méandres.

Un élément de l'adaptateur de la figure 3 identique ou similaire à un élément correspondant de l'adaptateur de la figure 1 est repéré par le même chiffre de référence que cet élément correspondant augmenté de deux centaines.

Dans l'adaptateur d'antenne 1040, le senseur magnétique 1012 est constitué d'une pluralité de senseur magnétiques élémentaires 1012-i, qui sont disposés selon une rangée, de manière à ce que leurs surfaces Si respectives soient dans le même plan P. Les senseurs élémentaires 1012-i sont connectés en série entre les bornes d'entrée E1 et E2 du circuit de contrôle 1014.

Les premier et second fils 1006 et 1016 sont conformés de manière à cheminer parallèlement l'un à l'autre dans le plan P. Ils sont séparés l'un de l'autre d'un pas réduit par rapport à leur largeurs respectives.

Les fils conducteurs 1006 et 1016 sont configurés de manière à circuler entre deux senseurs magnétiques élémentaires 1012-i en formant un méandre.

Le courant externe $i_{ext}(t)$ est appliqué dans le premier fil 1006 de manière à circuler dans un sens et le courant de contre réaction $i_{CR}(t)$ est appliqué dans le second fil 1016 de manière à circuler dans l'autre sens.

Le champ magnétique généré par un fil présente, dans le plan P des surfaces Si des senseurs magnétiques élémentaires, une orientation selon la direction normale au plan P, qui est positive d'un côté du fil et négative de l'autre côté du fil.

Dans l'adaptateur 1040, les senseurs magnétiques élémentaires 1012-i sont asymétriques, leur réponse étant telle que : $V(-\phi) = -V(\phi)$. Il s'agit par exemple de SQUID. Il faut alors espacer les senseurs magnétiques élémentaires 1012-i d'un méandre sur deux, afin que les réponses des senseurs magnétiques élémentaires ne s'annulent pas deux à deux compte tenu de l'inversion de l'orientation des champs magnétiques externe et de contre réaction d'un méandre à l'autre.

Un élément de l'adaptateur de la figure 4 identique ou similaire à un élément correspondant de l'adaptateur de la figure 1 est repéré par le même chiffre de référence que cet élément correspondant augmenté de trois centaines.

Dans l'adaptateur 1140 de la figure 4, toutes choses égales par ailleurs par rapport à l'adaptateur 1040 de la figure 3, les senseurs magnétiques élémentaires 1112-i sont symétriques, leur réponse étant telle que : $V(-\phi) = V(\phi)$. C'est le cas par exemple des senseurs magnétiques supraconducteurs du type SQIF. Leur réponse étant indépendante du sens du champ magnétique, on peut alors avantageusement placer des senseurs magnétiques élémentaires 1112-i dans chacun des méandres définis par les premier et second fils 1106 et 1116. La densité de senseurs magnétiques élémentaires peut ainsi être augmentée, ce qui à surface constante permet d'augmenter la sensibilité de l'adaptateur d'antenne.

La configuration en méandres introduit une inductance et une résistance radiative parasites, d'où une limitation de la bande passante. Cependant, la configuration en méandres est caractérisée par une inductance et une résistance radiative qui sont intrinsèquement plus faibles que celle de la configuration en boucle, ce qui permet de repousser davantage la fréquence de coupure haute de la bande passante de l'adaptateur d'antenne.

Là encore, par le choix de très petites dimensions pour le circuit formé par le fil 1016 ou 1116, la résistance radiative peut être réduite de façon à repousser au maximum la fréquence de coupure haute du capteur.

De plus, il est possible d'optimiser les paramètres géométriques. Par exemple, la distance x entre le second fil 1016, respectivement 1116, et l'axe des senseurs magnétiques 1012-i, respectivement 1112-i, peut être augmentée. Le champ magnétique créé par un fil diminuant en 1/x, pour obtenir le même flux de contre réaction, il faut alors augmenter le courant de contre réaction. Ceci présente l'avantage de permettre la détection de champs magnétiques externes de très faible amplitude (selon la normale à la surface Si des senseurs magnétiques), c'est-à-dire de courant externe de faible amplitude, grâce à l'utilisation de courant de contre réaction d'intensité élevée.

Cette configuration en méandres autorise une intégration dense à une ou deux dimensions dans le plan P, comme cela est représenté schématiquement sur la figure 6.

Cette configuration en méandres permet la réalisation d'un adaptateur d'antenne aux dimensions réduites.

La configuration en méandres est d'ailleurs plus avantageuse que la configuration en boucle, car plus simple à optimiser et à intégrer à grande échelle.

Ainsi, l'adaptateur d'antenne selon l'invention possède une large bande passante sur laquelle, lorsque le senseur magnétique est du type supraconducteur, il possède une très haute sensibilité. Par une conception appropriée du capteur magnétométrique, il est possible d'envisager une bande passante s'étalant de la très basse fréquence VLF (pour « Very Low Frequency » en anglais), à l'ultra-haute fréquence UHF (pour « Ultra High frequency » en anglais), c'est-à-dire entre environ quelques kHz et environ 1 000 MHz.

L'adaptateur d'antenne présente également une réponse intrinsèquement linéaire par rapport à l'intensité du courant externe à mesurer. De plus, cette réponse est uniforme sur toute la bande passante, c'est-à-dire qu'elle est indépendante de la fréquence du courant externe à mesurer.

En termes d'intensité du courant d'antenne mesurable, l'adaptateur d'antenne peut être adapté : segmentation en domaines de courant de contre réaction du circuit de contrôle, dimensionnement optimisé du circuit en boucle/méandres des deux fils conducteurs, intégration multi-échelle, etc.

Eventuellement, des filtres passe-bas peuvent être introduits dans le circuit de contrôle, pour permettre de spécifier un certain nombre de plages d'utilisation en fréquence, soit par ordre de grandeur fréquentiel du courant externe à mesurer, soit par domaines fréquentiels d'intérêt.

L'adaptateur d'antenne offre enfin la possibilité d'une intégration planaire haute-densité et dimensionnable à l'échelle multi-centimétrique.

## Revendications

1. Adaptateur d'antenne (840) destiné à être placé entre une antenne (830) et une chaîne de réception (850) et comportant :

    - un premier fil conducteur (806) parcouru par un courant externe ($i_{ext}$) correspondant à un signal délivré en sortie de l'antenne, le premier fil créant dans son voisinage un champ magnétique externe ($B_{ext}$) ;
    - un capteur magnétométrique (810) placé dans le voisinage du premier fil conducteur, sensible à un flux du champ magnétique externe et propre à générer un signal de sortie correspondant au courant externe,

    **caractérisé en ce que** le capteur magnétométrique (810) comporte :

    - un magnétomètre (812) ayant une surface active (S) et générant un signal de réponse ($V(\phi)$) lorsqu'il est plongé dans un champ magnétique créant un flux magnétique ($\phi$) à travers la surface active ;
    - un circuit de contrôle (814), prenant en entrée le signal de réponse du magnétomètre et générant en sortie un courant de contre-réaction ($i_{CR}$) ; et,
    - un second fil conducteur (816) disposé au voisinage du magnétomètre (812) et connecté en sortie du circuit de contrôle, le fil étant traversé par le courant de contre-réaction,

    le circuit et le fil conducteur étant tels qu'un champ magnétique de contre-réaction est créé dont le flux à travers la surface active du magnétomètre compense substantiellement, à chaque instant, le flux du champ magnétique externe,
    le signal de sortie du de l'adaptateur d'antenne correspondant au courant de contre réaction,
    les premier et second fils (806, 816) étant disposés dans un plan (P) de la surface (S) du magnétomètre (812).

**2.** Adaptateur d'antenne (840) selon la revendication 1, dans lequel le senseur magnétique (812) est un senseur magnétique supraconducteur.

**3.** Adaptateur d'antenne (840) selon la revendication 1 ou la revendication 2, dans lequel le circuit de contrôle (814) comporte un moyen de comparaison (822) propre à comparer le signal de réponse du magnétomètre (812) par rapport à un signal de référence ($V_0$) et à générer un signal de comparaison, et une source de courant (824) commandée par le signal de comparaison, propre à générer le courant de contre-réaction ($i_{CR}(t)$).

**4.** Adaptateur d'antenne (840) selon l'une quelconque des revendications précédentes, ayant une bande passante étendue et une réponse linéaire et uniforme sur ladite bande passante.

**5.** Adaptateur d'antenne (1040) selon l'une quelconque des revendications précédentes, dans lequel le senseur magnétique (1012) est constitué d'une pluralité de magnétomètres élémentaires (1012i) connectés en série entre deux bornes d'entrée du circuit de contrôle (1014).

**6.** Adaptateur d'antenne (1040 ; 1140) selon l'une quelconque des revendications précédentes, dans lequel le premier et le second fils conducteurs sont conformés de manière à cheminer parallèlement dans le plan de la surface du senseur magnétique, le courant extérieur ($i_{ext}(t)$) circulant dans un premier sens et le courant de contre-réaction ($i_{CR}(t)$) circulant dans un second sens opposé au premier.

**7.** Adaptateur d'antenne (840 ; 940) selon l'une quelconque des revendications précédentes, dans lequel le premier fil et/ou le second fil forme(nt) une boucle autour de la surface du senseur magnétique (812 ; 912), la boucle comportant au moins une spire.

**8.** Adaptateur d'antenne (1040 ; 1140) selon l'une quelconque des revendications précédentes, dans lequel, le senseur magnétique (1012 ; 1112) étant constitué d'une pluralité de senseurs magnétiques élémentaires (1012-i ; 1112-i) connectées en série entre des bornes d'entrée du circuit de contrôle (1014 ; 1114), le premier fil et le second fil forment une pluralité de méandres autour d'une pluralité de senseurs magnétiques élémentaires (1012-i ; 1112-i).

**9.** Adaptateur d'antenne (1040 ; 1140) selon la revendication 8, dans lequel, lesdits senseurs magnétiques élémentaires (1012-i) étant asymétriques, les senseurs magnétiques élémentaires sont disposés dans un méandre sur deux, ou, lesdits senseurs magnétiques élémentaires (1112-i) étant symétriques, les senseurs magnétiques élémentaires sont disposés dans chaque méandre.

**10.** Adaptateur d'antenne (840) selon l'une quelconque des revendications précédentes, dans lequel le capteur magnétométrique et une portion du premier fil conducteur sont placés dans un carter (802) permettant une isolation magnétique vis-à-vis du monde extérieur.

**Patentansprüche**

**1.** Antennenadapter (840), der vorgesehen ist, um zwischen einer Antenne (830) und eine Empfangskette (850) angeordnet zu sein, und welcher aufweist:

- eine erste Leiter-Leitung (806), die von einem externen Strom ($i_{ext}$) durchflossen wird, der zu einem Signal korrespondiert, welches am Ausgang der Antenne geliefert wird, wobei die erste Leitung in ihrer Umgebung ein externes Magnetfeld ($B_{ext}$) erzeugt,
- einen magnetometrischen Sensor (810), welcher in der Umgebung der ersten Leiter-Leitung angeordnet ist, der empfindlich auf einen Fluss des externes Magnetfeldes ist und der imstande ist, ein Ausgangssignal zu erzeugen, welches zu dem externen Strom korrespondiert,

**dadurch gekennzeichnet, dass** der magnetometrische Sensor (810) aufweist:

- ein Magnetometer (812), welches eine aktive Fläche (S) hat und ein Antwortsignal ($V(\Phi)$) erzeugt, wenn es in ein Magnetfeld getaucht wird, welches einen magnetischen Fluss ($\Phi$) durch die aktive Fläche erzeugt,
- einen Steuerungs-Schaltkreis (814), welcher am Eingang das Antwortsignal des Magnetometers annimmt und am Ausgang einen Rückkopplungs-Strom ($i_{CR}$) erzeugt, und
- eine zweite Leiter-Leitung (816), welche in der Umgebung des Magnetometers (812) angeordnet ist und mit dem Ausgang des Steuerungs-Schaltkreises verbunden ist, wobei die Leitung von dem Rückkopplungs-Strom durchflossen wird,

wobei der Schaltkreis und die Leiter-Leitung derart beschaffen sind, dass ein Rückkopplungs-Magnetfeld erzeugt wird, dessen Fluss durch die aktive Fläche des Magnetometers zu jeder Zeit im Wesentlichen den Fluss des externen Magnetfeldes kompensiert,

wobei das Ausgangssignal des Antennenadapters zu dem Rückkopplungs-Strom korrespondiert,

wobei die erste und die zweite Leitung (806, 816) in einer Ebene (P) der Fläche (S) des Magnetometers (812) angeordnet sind.

2. Antennenadapter (840) gemäß Anspruch 1, wobei der Magnetsensor (812) ein Supraleiter-Magnetsensor ist.

3. Antennenadapter (840) gemäß Anspruch 1 oder Anspruch 2, wobei der Steuerungs-Schaltkreis (814) aufweist ein Mittel zum Vergleichen (822), welches imstande ist, das Antwortsignal des Magnetometers (812) bezüglich eines Referenzsignals ($V_0$) zu vergleichen und ein Vergleichssignals zu erzeugen, und eine Stromquelle (824), die mittels des Vergleichssignals gesteuert wird, die imstande ist, den Rückkopplungs-Strom ($i_{CR}(t)$) zu erzeugen.

4. Antennenadapter (840) gemäß irgendeinem der vorherigen Ansprüche, welcher eine erweiterte Bandbreite und eine lineare sowie uniforme Antwort auf die besagte Bandbreite hat.

5. Antennenadapter (1040) gemäß irgendeinem der vorherigen Ansprüche, wobei der Magnetsensor (1012) aus einer Mehrzahl von elementaren Magnetometern (1012i) gebildet ist, die in Reihe zwischen zwei Eingangsanschlüssen des Steuerungs-Schaltkreises (1014) geschaltet sind.

6. Antennenadapter (1040, 1140) gemäß irgendeinem der vorherigen Ansprüche, wobei die erste und die zweite Leiter-Leitung auf eine Weise angepasst sind, um in der Ebene der Fläche des Magnetsensors parallel zu verlaufen, wobei äußere Strom ($i_{ext}(t)$) in einer ersten Richtung fließt und der Rückkopplungs-Strom ($i_{CR}(t)$) in einer zweiten Richtung fließt, die entgegengesetzt zur ersten ist.

7. Antennenadapter (840, 940) gemäß irgendeinem der vorherigen Ansprüche, wobei der erste Leiter und/oder der zweite Leiter eine Schlaufe um die Fläche des Magnetsensors (812, 912) herum bildet/bilden, wobei die Schlaufe mindestens eine Windung aufweist.

8. Antennenadapter (1040, 1140) gemäß irgendeinem der vorherigen Ansprüche, wobei der Magnetsensor (1012, 1112) aus einer Mehrzahl von elementaren Magnetsensoren (1012-i, 1112-i) gebildet ist, die in Reihe zwischen Eingangsanschlüssen des Steuerungs-Schaltkreises (1014, 1114) geschaltet sind, wobei die erste Leitung und die zweite Leitung eine Mehrzahl von Mäandern um die Mehrzahl von elementaren Magnetsensoren (1012-i, 1112-i) herum bilden.

9. Antennenadapter (1040, 1140) gemäß Anspruch 8, wobei, wenn die besagten elementaren Magnetsensoren (1012-i) asymmetrisch sind, die elementaren Magnetsensoren in jeder zweiten Mäander angeordnet sind, oder, wenn die besagten elementaren Magnetsensoren (1112-i) symmetrisch sind, die elementaren Magnetsensoren in jeder Mäander angeordnet sind.

10. Antennenadapter (840) gemäß irgendeinem der vorherigen Ansprüche, wobei der magnetometrische Sensor und ein Abschnitt der ersten Leiter-Leitung in einem Gehäuse (802) angeordnet sind, welches eine magnetische Isolation gegenüber der Außenwelt erlaubt.

**Claims**

1. An antenna adaptor (840) intended to be placed between an antenna (830) and a receiving channel (850), and including :

   - a first conductive wire (806) crossed by an external current ($i_{ext}$) corresponding to a signal delivered at the output of the antenna, the first conductive wire generating in its vicinity an external magnetic field ($B_{ext}$);
   - a magnetometric sensor (810) placed in the vicinity of the first conductive wire, sensitive to a flux of the external magnetic field and able to generate an output signal corresponding to the external current,

   **characterized in that** the magnetometric sensor (810) includes:

   - a magnetometer (812) having an active surface (S) and generating a response signal ($V(\phi)$) when it is immersed in a magnetic field generating a magnetic flux ($\phi$) through the active surface;
   - a control circuit (814), taking as an input the response signal of the magnetometer and generating at the output a feedback current ($i_{CR}$); and,
   - a second conductive wire (816) positioned in the vicinity of the magnetometer (812) and connected at the output of the control circuit, the second conductive wire being crossed by the feedback current,

   the control circuit and the second conductive wire being such that a feedback magnetic field is generated, the flux of which through the active surface of the magnetometer substantially compensates, at each instant, for the flux of the external magnetic field,
   the output signal of the antenna adaptor corresponding to the feedback current,
the first and second wires (806, 816) being located in a plane (P) of the surface (S) of the magnetometer (812).

2. The antenna adaptor (840) according to claim 1, wherein the magnetometer (812) is a superconducting magnetic sensor.

3. The antenna adaptor (840) according to claim 1 or claim 2, wherein the control circuit (814) includes a comparison means (822) able to compare the response signal of the magnetometer (812) relatively to a reference signal ($V_0$) and to generate a comparison signal, and a current source (824) controlled by the comparison signal, able to generate the feedback current ($i_{CR}(t)$).

4. The antenna adaptor (840) according to any of the preceding claims, having an extended pass band and a linear and uniform response on said pass band.

5. The antenna adaptor (1040) according to any of the preceding claims, wherein the magnetometer (1012) consists of a plurality of elementary magnetometers (1012i) connected in series between two input terminals of the control circuit (1014).

6. The antenna adaptor (1040; 1140) according to any of the preceding claims, wherein the first and the second conductive wires are conformed so as to progress in parallel in the plane of the surface of the magnetometer, the external current ($i_{ext}(t)$) circulating in a first direction and the feedback current ($i_{CR}(t)$) circulating in a second direction opposite to the first direction.

7. The antenna adaptor (840; 940) according to any of claims 2 to 7, wherein the first wire and/or the second conductive wire form a loop around the surface of the magnetometer (812; 912), the loop including at least one turn.

8. The antenna adaptor (1040; 1140) according to any of the preceding claims, wherein, the magnetometer (1012; 1112) consisting of a plurality of elementary magnetic sensors (1012-i; 1112-i) connected in series between input terminals of the control circuit (1014; 1114), the first conductive wire and the second conductive wire form a plurality of meanders around a plurality of elementary magnetic sensors (1012-i; 1112-i).

9. The antenna adaptor (1040; 1140) according to claim 8, wherein, as said elementary magnetic sensors (1012-i) are asymmetrical, the elementary magnetic sensors are positioned in one meander out of two, or, as said elementary magnetic sensors (1112-i) are symmetrical, the elementary magnetic sensors are positioned in each meander.

10. The antenna adaptor (840) according to any of the preceding claims, wherein the magnetometric sensor and a portion of the first conductive wire are placed in a case (802) allowing magnetic isolation towards the outside world.

FIG.1

FIG.2

FIG.3

FIG.4

FIG.5

FIG.6

## RÉFÉRENCES CITÉES DANS LA DESCRIPTION

**Documents brevets cités dans la description**

- EP 1039307 A1
- US 5285155 A